# EUROPEAN PATENT APPLICATION

(11) **EP 4 693 413 A1**
(43) Date of publication of application: **11.02.2026**
(21) Application number: 24779316.9
(22) Date of filing: 08.03.2024
(51) Int. Cl.: H01L 31/048, E06B 5/00, H02S 20/26, H02S 40/34

(54) **SOLAR BATTERY MULTILAYER GLASS AND GLASS WINDOW**

(30) Priority: 24.03.2023 JP 2023048861
(71) Applicant: LIXIL Corporation, Tokyo 141-0033 (JP)
(72) Inventor: ISHII, Hisashi, Tokyo 141-0033 (JP)
(74) Representative: karo IP
(86) International application number: PCT/JP2024/009149
(87) International publication number: WO 2024/203185

(57) **Abstract**

Solar cell multi-glazed glass 10 in which a hollow layer 18 is provided between a pair of glass panels 12 and 14 includes: a first transparent conductive film layer 26 provided on a surface of at least one of the pair of glass panels 12 and 14; a solar cell layer 28 provided on the first transparent conductive film layer 26; and a second transparent conductive film layer 30 provided on the solar cell layer 28.

## Description

### TECHNICAL FIELD

The present invention relates to multi-glazed glass equipped with solar cells.

### BACKGROUND ART

Conventionally, solar cell glass of laminated glass type is known in which a solar cell layer is provided between a pair of glass panels. Further, solar cell multi-glazed glass of laminated multi-glazed glass type is also known in which a hollow layer is provided between solar cell glass of laminated glass type and a glass panel (see Patent Literature 1, for example).

### RELATED-ART LITERATURE

### PATENT LITERATURE

Patent Literature 1: Japanese Patent Application Laid-Open Publication No. 2017-85750

### SUMMARY OF INVENTION

### TECHNICAL PROBLEM

However, the solar cell multi-glazed glass of laminated multi-glazed glass type has the problem of increased estimated dimensions. As the estimated dimensions increase, the opening dimensions and cross-sectional shape of the frame also need to be significantly modified. In addition, because of the increased weight and shift in the position of the center of gravity, it is necessary to increase the cross-sectional performance, moment of inertia of area, and polar moment of inertia of area, in order to suppress deflection and torsion.

The present invention has been made in view of such a problem, and a purpose thereof is to provide solar cell multi-glazed glass of which an increase in estimated dimensions is reduced.

### SOLUTION TO PROBLEM

To solve the problem above, solar cell multi-glazed glass according to one embodiment of the present invention is solar cell multi-glazed glass in which a hollow layer is provided between a pair of glass panels. The solar cell multi-glazed glass includes: a first transparent conductive film layer provided on a surface of at least one of the pair of glass panels; a solar cell layer provided on the first transparent conductive film layer; and a second transparent conductive film layer provided on the solar cell layer.

Another embodiment of the present invention is a glass window that includes the abovementioned solar cell multi-glazed glass, and a frame that supports an outer circumferential edge of the solar cell multi-glazed glass.

### BRIEF DESCRIPTION OF DRAWINGS

[Fig. 1] Fig. 1 is a schematic sectional view of solar cell multi-glazed glass according to a first embodiment.
[Fig. 2] Fig. 2 is a schematic sectional view of solar cell multi-glazed glass according to a second embodiment.

### DESCRIPTION OF EMBODIMENTS

In the following, the present invention will be described based on preferred embodiments with reference to the drawings. The configurations described below are intended for illustration for understanding of the present disclosure, and the scope of the present disclosure is defined only by the scope of the claims attached herein. Like reference characters denote like or corresponding constituting elements and members in each drawing, and repetitive description will be omitted as appropriate. Also, the dimensions of a member may be appropriately enlarged or reduced in each drawing in order to facilitate understanding. Further, in each drawing, part of a member less important in describing the embodiments may be omitted.

### First Embodiment

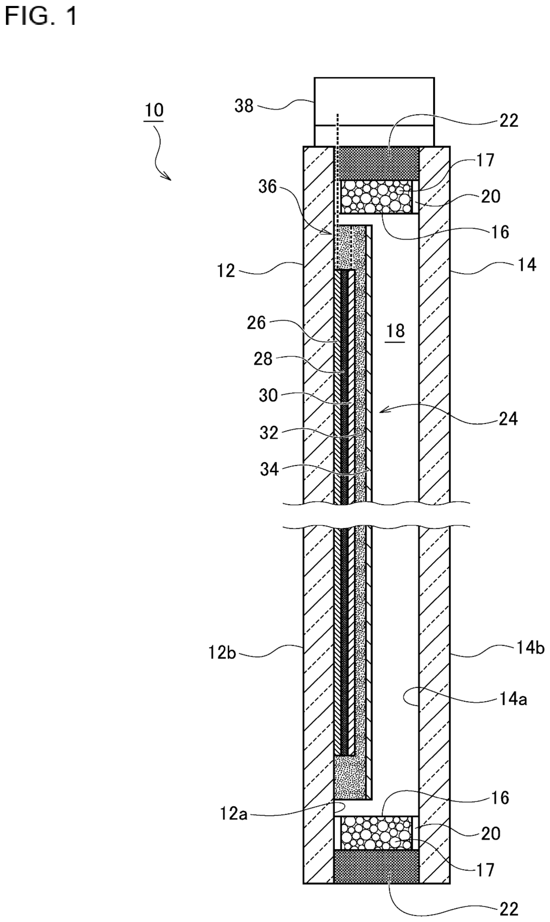

Fig. 1 is a schematic sectional view of solar cell multi-glazed glass 10 according to the first embodiment. The outer circumferential edge of the solar cell multi-glazed glass 10 shown in Fig. 1 is supported by a frame (sash). A glass window including the solar cell multi-glazed glass 10 and the frame is placed in an opening of a building.

As shown in Fig. 1, the solar cell multi-glazed glass 10 includes a pair of glass panels 12 and 14 (hereinafter, referred to as the outdoor glass panel 12 and indoor glass panel 14, as appropriate) having translucency, and a spacer 16.

The solar cell multi-glazed glass 10 is configured as multi-glazed glass in which a hollow layer 18 is provided between the pair of glass panels 12 and 14 by means of the spacer 16, and dry air is sealed in the hollow layer 18. In the spacer 16, a hygroscopic agent 17 is provided to keep the air in the hollow layer 18 dry.

The circumferential edges of the pair of glass panels 12 and 14 are sealed by a sealing material, and the hollow layer 18 is sealed with no outside air flowing therein. The sealing material includes a primary sealing material 20 that seals between the spacer 16 and the pair of glass panels 12 and 14, and a secondary sealing material 22 that is disposed outside the spacer 16 and the primary sealing material 20 and that seals between the pair of glass panels 12 and 14. In the hollow layer 18, a noble gas such as Kr (krypton) and Ar (argon) may be sealed.

In the solar cell multi-glazed glass 10, an inner surface 12a of the outdoor glass panel 12 and an inner surface 14a of the indoor glass panel 14 face each other. Also, an outer surface 12b of the outdoor glass panel 12 faces the external space of the building, and an outer surface 14b of the indoor glass panel 14 faces the interior space.

The solar cell multi-glazed glass 10 includes a solar cell module 24 in the hollow layer 18. The solar cell module 24 is provided on the inner surface 12a of the outdoor glass panel 12.

The solar cell module 24 includes a first transparent conductive film layer 26 provided on the inner surface 12a of the outdoor glass panel 12, a solar cell layer 28 provided on the first transparent conductive film layer 26, a second transparent conductive film layer 30 provided on the solar cell layer 28, an encapsulation layer 32 provided to cover the first transparent conductive film layer 26, solar cell layer 28, and second transparent conductive film layer 30, and a protection layer 34 provided to cover the encapsulation layer 32. These layers can be formed by performing a process such as vapor deposition on the inner surface 12a of the outdoor glass panel 12.

The first transparent conductive film layer 26 and the second transparent conductive film layer 30 are provided to extract electricity generated in the solar cell layer 28 and are formed to sandwich the solar cell layer 28. The first transparent conductive film layer 26 and the second transparent conductive film layer 30 may be formed of indium tin oxide (ITO), for example.

The solar cell layer 28 is a layer in which multiple solar cells are arranged. The solar cells use photovoltaic effect and convert solar energy into electricity. In the solar cell layer 28, multiple solar cells are electrically connected in series to obtain a required predetermined voltage. Also, a plurality of such multiple solar cells electrically connected in series are collected and connected in parallel to obtain a required current. The solar cell layer 28 may be made of thin-film silicon. The solar cell layer 28 may be translucent or may be colored. The solar cells may be of monofacial type or may be of bifacial type.

For the encapsulation layer 32, ethylen-vinyl acetate (EVA), which is lightweight and durable, polyvinyl butyral (PVB), ionomers, silicone, and the like can be used, for example. The thickness of the encapsulation layer 32 may be about 150 µm to 300 µm. The protection layer 34 may be formed, for example, using ETFE (Ethylene Tetra Fluoro Ethylene), polycarbonate (PC), polyethylene (PET), polystyrene (PS), polypropylene (PP), and the like. The thickness of the protection layer 34 may be about 25 µm.

By sealing Ar gas or Kr gas in the hollow layer 18, thermal insulation properties are improved and no oxygen exists, so that oxidation can be suppressed to some extent even in the state where the second transparent conductive film layer 30 is exposed. However, by providing the encapsulation layer 32 and the protection layer 34, durability can be further improved.

At an end of each of the first transparent conductive film layer 26 and the second transparent conductive film layer 30, an extraction electrode 36 is provided to extract the current generated in the solar cell layer 28 to the outside. The extraction electrode 36 is extended out of the hollow layer 18 through the primary sealing material 20 and the secondary sealing material 22. The extraction electrode 36 thus extended is further extended into a terminal box 38 provided in an upper part of the solar cell multi-glazed glass 10 and is connected to a wiring cable (not illustrated) in the terminal box 38. The terminal box 38 is not limited to the upper part of the solar cell multi-glazed glass 10 and may be disposed in a side part or a lower part of the solar cell multi-glazed glass 10.

In the solar cell multi-glazed glass 10 configured as described above, since the solar cell module 24 is provided on the inner surface 12a of the outdoor glass panel 12, an increase in the estimated dimensions can be significantly reduced and the weight can also be significantly reduced, compared to conventional solar cell multi-glazed glass of laminated multi-glazed glass type. Although it depends on the thickness of the solar cell module 24, the estimated dimensions can be made almost the same as those of ordinary multi-glazed glass. Also, since the position of center of gravity does not change significantly compared to ordinary multi-glazed glass, there is no need to increase the cross-sectional performance, moment of inertia of area, and polar moment of inertia of area.

In the embodiment shown in Fig. 1, the solar cell module 24 is provided on the inner surface 12a of the outdoor glass panel 12. However, the surface on which the solar cell module 24 is provided is not limited thereto, and the solar cell module 24 may be provided on the outer surface 12b of the outdoor glass panel 12, the inner surface 14a of the indoor glass panel 14, or the outer surface 14b of the indoor glass panel 14. Also, the solar cell module 24 may be provided on two or more surfaces.

### Second Embodiment

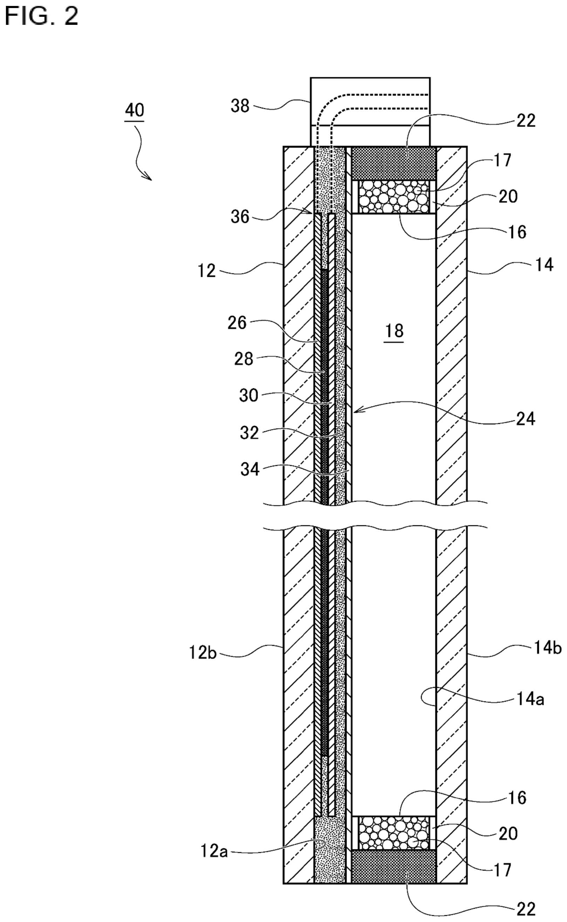

Fig. 2 is a schematic sectional view of solar cell multi-glazed glass 40 according to the second embodiment. The solar cell multi-glazed glass 40 according to the second embodiment differs from the solar cell multi-glazed glass 10 according to the first embodiment in the sealing process for the circumferential edges of the glass panels.

As shown in Fig. 2, in the solar cell multi-glazed glass 40, the encapsulation layer 32 and the protection layer 34 extend to the ends of the outdoor glass panel 12. The circumferential edges of the pair of glass panels 12 and 14 are sealed by the primary sealing material 20 and the secondary sealing material 22, with the intervention of the ends of the encapsulation layer 32 and the protection layer 34. In other words, the sealing materials are provided between the protection layer 34 on the outdoor glass panel 12 and the inner surface 14a of the indoor glass panel 14.

At an end of each of the first transparent conductive film layer 26 and the second transparent conductive film layer 30, an extraction electrode 36 is provided to extract the current generated in the solar cell layer 28 to the outside. In the solar cell multi-glazed glass 40 according to the second embodiment, the extraction electrode 36 is extended out of the hollow layer 18 through the encapsulation layer 32. The extraction electrode 36 thus extended is further extended into the terminal box 38 provided in an upper part of the solar cell multi-glazed glass 10 and is connected to the wiring cable (not illustrated) in the terminal box 38. The terminal box 38 is not limited to the upper part of the solar cell multi-glazed glass 10 and may be disposed in a side part or a lower part of the solar cell multi-glazed glass 10.

The present invention has been described with reference to embodiments. The embodiments are intended to be illustrative only, and it will be obvious to those skilled in the art that various modifications and changes could be developed within the scope of claims of the present invention and that such modifications and changes also fall within the scope of claims of the present invention. Therefore, the description in the present specification and the drawings should be regarded as illustrative rather than limitative.

### INDUSTRIAL APPLICABILITY

The present invention is applicable to multi-glazed glass equipped with solar cells.

### REFERENCE SIGNS LIST

10, 40 solar cell multi-glazed glass, 12 outdoor glass panel, 14 indoor glass panel, 18 hollow layer, 20 primary sealing material, 22 secondary sealing material, 24 solar cell module, 26 first transparent conductive film layer, 28 solar cell layer, 30 second transparent conductive film layer, 32 encapsulation layer, 34 protection layer, 36 extraction electrode, 38 terminal box

## Claims

1. Solar cell multi-glazed glass in which a hollow layer is provided between a pair of glass panels, the solar cell multi-glazed glass comprising:
a first transparent conductive film layer provided on a surface of at least one of the pair of glass panels;
a solar cell layer provided on the first transparent conductive film layer; and
a second transparent conductive film layer provided on the solar cell layer.

2. The solar cell multi-glazed glass according to Claim 1, further comprising an encapsulation layer provided to cover the first transparent conductive film layer, the solar cell layer, and the second transparent conductive film layer.

3. The solar cell multi-glazed glass according to Claim 2, further comprising a protection layer provided to cover the encapsulation layer.

4. The solar cell multi-glazed glass according to any one of Claims 1 through 3, further comprising a sealing material that seals circumferential edges of the pair of glass panels,
wherein an extraction electrode is provided at an end of each of the first transparent conductive film layer and the second transparent conductive film layer to extract a current generated in the solar cell layer to the outside, and
wherein the extraction electrode is extended out of the hollow layer through the sealing material.

5. The solar cell multi-glazed glass according to Claim 2 or 3,
wherein the encapsulation layer extends to an end of at least one of the pair of glass panels,
the solar cell multi-glazed glass further comprising a sealing material that seals circumferential edges of the pair of glass panels, with the intervention of an end of the encapsulation layer,
wherein an extraction electrode is provided at an end of each of the first transparent conductive film layer and the second transparent conductive film layer to extract a current generated in the solar cell layer to the outside, and
wherein the extraction electrode is extended out of the hollow layer through the encapsulation layer.

6. A glass window comprising:
the solar cell multi-glazed glass according to any one of Claims 1 through 5; and
a frame that supports an outer circumferential edge of the solar cell multi-glazed glass.
